# FASCICULE DE BREVET EUROPEEN

(11) **EP 1 340 296 B1**
(45) Date de publication et mention de la délivrance du brevet: **07.05.2008**
(21) Numéro de dépôt: 01997873.3
(22) Date de dépôt: 23.11.2001
(51) Int. Cl.: H01S 5/327

(54) **LASER A ZNO POLYCRISTALLIN POMPE ELECTRIQUEMENT ET PROCEDE DE REALISATION**
ELEKTRISCH GEPUMPTER POLYKRISTALLINER ZNO LASER UND DESSEN HERSTELLUNGSVERFAHREN
ELECTRICALLY PUMPED POLYCRYSTALLINE ZNO LASER AND METHOD FOR MAKING SAME

(30) Priorité: 23.11.2000 FR 0015107
(43) Date de publication de la demande: 03.09.2003
(73) Titulaire: Rogers, David J., 91190 Gif-sur-Yvette (FR)
(72) Inventeur: Rogers, David J., 91190 Gif-sur-Yvette (FR)
(74) Mandataire: Breese, Pierre
(86) Numéro de dépôt international: PCT/FR2001/003711
(87) Numéro de publication internationale: WO 2002/043207

(56) Documents cités:
- EP-A- 0 863 555
- WO-A-00/16411
- US-A- 4 081 764
- KAWASAKI M ET AL: "Excitonic ultraviolet laser emission at room temperature from naturally made cavity in ZnO nanocrystal thin films" MATERIALS SCIENCE AND ENGINEERING B, ELSEVIER SEQUOIA, LAUSANNE, CH, vol. 56, no. 2-3, 6 novembre 1998 (1998-11-06), pages 239-245, XP004152908 ISSN: 0921-5107

## Description

### Domaine technique

La présente invention a pour objet un laser à ZnO polycristallin pompé électriquement et un procédé de réalisation de ce laser.

### Etat de la technique antérieure

On connaît des lasers à semiconducteur comprenant une couche mince de ZnO polycristallin et des moyens de pompage optique. L'article de H. CAO et al. intitulé "Ultraviolet lasing in resonators formed by scattering in semiconductor polycristalline films", publié dans la revue "Applied Physics Letters", vol. 73, n°25, 21 décembre 1998, pp. 3656-3658, décrit ainsi un laser où les cavités résonnantes sont auto-constituées en raison de la forte diffusion optique dans le milieu actif. Ce milieu est obtenu en faisant croître une couche mince d'oxyde de zinc polycristallin sur un substrat en silice fondue amorphe. Le milieu actif est pompé optiquement à l'aide d'un faisceau provenant d'un laser YAG-Nd à modes verrouillés, dont la fréquence est triplée pour atteindre 355 nm. L'émission laser s'effectue dans l'ultraviolet, à environ 380 nm.

Par ailleurs, l'article de Z.K. TANG et al. intitulé "Room-temperature ultraviolet laser emission from self-assembled ZnO microcrystalline thin film" publié dans la revue "Applied Physics Letters", vol. 72, n°25, 22 juin 1998, pp. 3270-3272 décrit un laser comprenant des microcristallites de ZnO hexagonal obtenues par MBE ("Molecular Beam Epitaxy"). Ces microcristallites se trouvent assemblées automatiquement sous forme de réseau sur un substrat en saphir. Là encore, le pompage est optique à partir de l'émission d'un laser YAG-Nd triplé en fréquence.

Le pompage optique de ces structures est complexe et les rend difficiles d'emploi. La présente invention a justement pour but de remédier à cet inconvénient.

On connaît déjà, par la demande EP-A-0863555, un laser conforme au préambule de la revendication 1.

### Exposé de 1' invention

A cette fin, l'invention propose un laser utilisant encore une couche de ZnO polycristallin mais autorisant un pompage électrique (et non plus optique), ce qui est une grande simplification.

De façon plus précise, la présente invention a pour objet un laser à semiconducteur à ZnO polycristallin, caractérisé en ce qu'il comprend:
- sur un substrat, une sous-couche constituée par un film mince polycristallin d'un matériau dont les paramètres de réseau cristallin sont adaptés à ceux de ZnO, cette sous-couche étant constituée d'une mosaïque de grains ayant un axe cristallographique perpendiculaire au plan du film,
- sur la sous-couche, une couche mince formée de grains de ZnO ayant un axe cristallographique perpendiculaire au plan de la couche, chaque grain étant entouré d'une paroi en un matériau électriquement isolant,
- des moyens de pompage électrique aptes à faire circuler un courant perpendiculairement au plan de la couche mince.

L'invention a également pour objet un procédé de réalisation d'un laser à semiconducteur à ZnO polycristallin conforme à la définition qui précède. Ce procédé est caractérisé en ce qu'il consiste à :
- déposer sur un substrat une sous-couche constituée par un film mince polycristallin d'un matériau dont les paramètres de réseau cristallin sont adaptés à ceux de ZnO, cette sous-couche étant constituée d'une mosaïque de grains ayant un axe cristallographique perpendiculaire au plan du film,
- faire croître sur la sous-couche une couche mince de ZnO en présence d'un matériau électriquement isolant donnant lieu à une ségrégation de composition avec ZnO, la croissance de la couche s'effectuant alors par grains de ZnO entourés d'une paroi en ledit matériau isolant.

De préférence, la sous-couche est, par exemple, en ZnO (wurtzite) ou GaN (wurtzite) ou AlN (wurtzite) ou MgO (rocksalt).

De préférence encore, le matériau électriquement isolant est en MgO ou CaO ou SrO, ou BiO, ou BaO, ou TiO₂, par exemple.

Les moyens permettant d'obtenir une cavité résonnante peuvent être, comme il est d'usage dans la technique des lasers à semiconducteur, des miroirs disposés de part et d'autre de la couche de ZnO, ou un réseau de Bragg réparti à la surface de ladite couche, ou tout autre moyen équivalent.

### Brève description des dessins

- la figure 1 montre, en vue de dessus, une couche mince de ZnO polycristallin avec des grains entourés d'une paroi électriquement conductrice selon l'art antérieur ;
- la figure 2 montre, en coupe transversale, un substrat et une couche polycristalline selon l'art antérieur ;
- la figure 3 montre, en vue de dessus, des grains entourés d'une paroi électriquement isolante conformément à l'invention ;
- la figure 4 montre, en coupe, un empilement avec une sous-couche et une couche de ZnO conformément à l'invention ;
- la figure 5 représente schématiquement un laser conforme à l'invention.

### Description de modes particuliers de réalisation

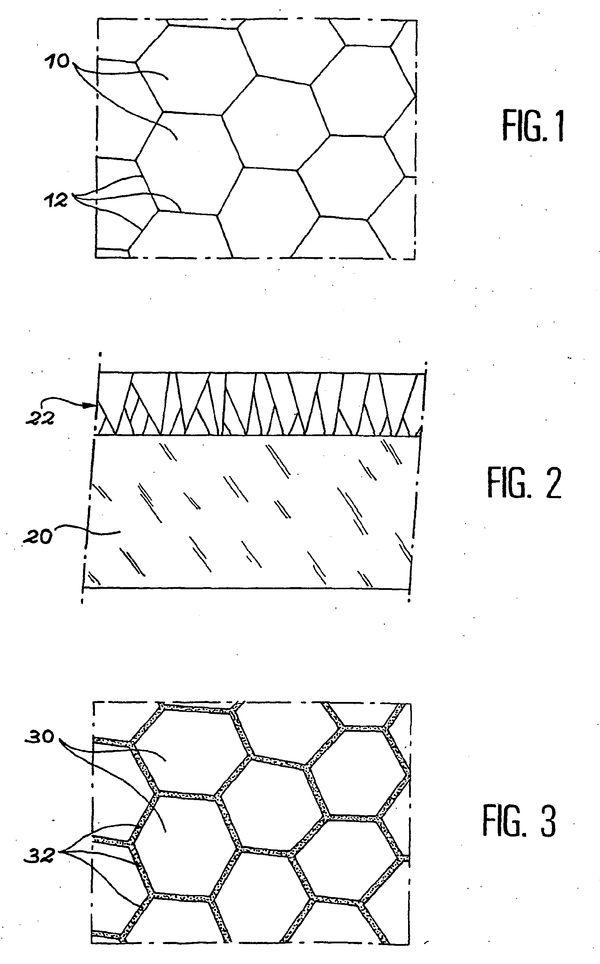

Sur les figures 1 et 2 on voit la structure d'une couche de ZnO polycristallin habituel, obtenu par les méthodes classiques de dépôt sous vide. Sur la figure 1, les grains sensiblement hexagonaux 10 sont séparés par des parois 12 électriquement conductrices. La figure 2 illustre la manière désordonnée dont les grains de la couche 22 croissent en partant du substrat 20.

Selon l'invention, on s'y prend comme suit :
- on dépose sur un substrat 40 une sous-couche 42 polycristalline ayant un paramètre de réseau adapté au réseau de ZnO ; cette sous-couche présente une structure en mosaïque : l'axe cristallographique c des grains est très fortement orienté perpendiculairement au plan du film et ces grains sont désordonnés dans le plan du film (plan dit "a-b) ;
- on fait croître sur cette sous-couche une couche 44 de ZnO en présence d'un élément qui ne s'incorpore pas à la structure cristalline wurtzite de ZnO mais qui donne lieu à une ségrégation de composition. Les grains de ZnO de la couche 44 croissent alors de manière régulière avec l'un des axes cristallographiques (c) perpendiculaire au plan de la couche, les deux autres axes (a-b) étant orientés de manière aléatoire dans le plan de la couche. Les grains sensiblement hexagonaux 30 (figure 3) sont entourés d'une paroi électriquement isolante 32.

L'épaisseur de la sous-couche polycristalline 42 est comprise entre environ 1 nm et environ 100 nm.

L'épaisseur de la couche 44 est comprise entre environ 1 nm et 1 mm.

Le substrat peut être en verre amorphe ou en quartz amorphe ou en silicium amorphe, par exemple.

Les dépôts de couche peuvent s'effectuer par pulvérisation magnétron RF ou par ablation laser.

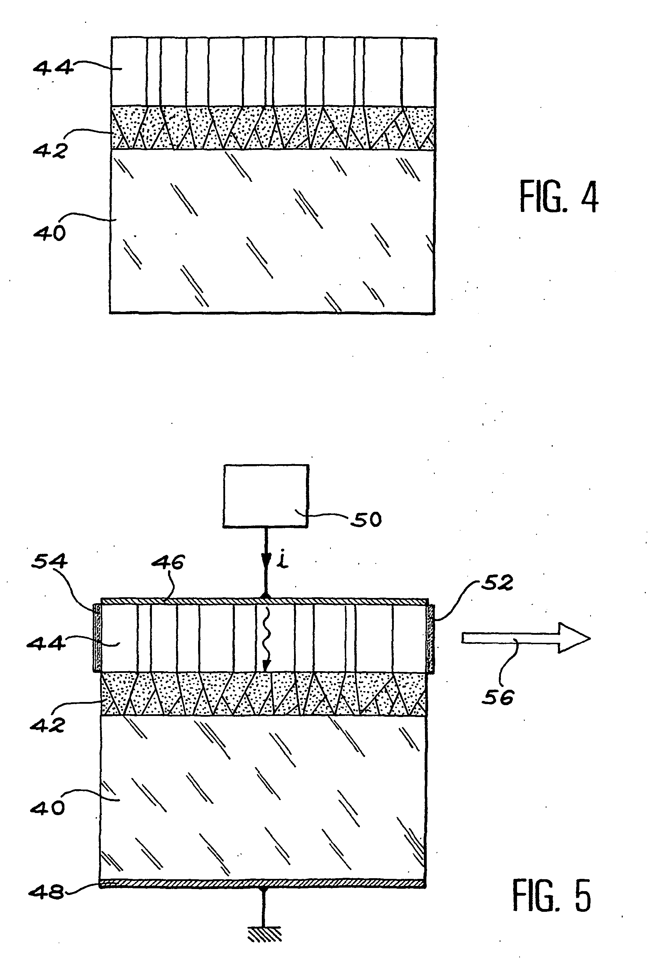

Comme on le voit sur la figure 5, l'empilement obtenu peut être complété par deux électrodes 46-48 dont l'une est reliée à un générateur de courant 50 et l'autre est à la masse. Deux miroirs 52 et 54 disposés de part et d'autre de la couche active 44 forment un résonateur. L'émission stimulée est symbolisée par la flèche 56. Elle se produit dans l'ultraviolet entre environ 245 nm (2450 Å) et 350 nm (3500 Å).

Le caractère régulier des grains et leur isolement électrique les uns des autres ont pour effet de canaliser les lignes de courant et d'éviter la diffusion de celui-ci. C'est ce qui rend le pompage électrique efficace.

## Revendications

1. Laser à semi-conducteur à ZnO polycristallin, **caractérisé en ce qu'**il comprend:
- un substrat (40),
- sur ledit substrat (40), une sous-couche (42) constituée par un film mince polycristallin d'un matériau dont les paramètres de réseau cristallin sont adaptés à ceux de ZnO, cette sous-couche étant constituée d'une mosaïque de grains ayant un axe cristallographique perpendiculaire au plan du film,
- sur la sous-couche (42), une couche mince (44) formée de grains (30) de ZnO,
- des moyens de pompage électrique (46, 48, 50) aptes à faire circuler un courant perpendiculairement au plan de la couche mince (44),
**caractérisé en ce que** :
les grains de la couche mince (44) ont un axe cristallographique perpendiculaire au plan de la couche mince (44) et sont isolés électriquement les uns des autres en entourant chaque grain d'une paroi en un matériau électriquement isolant.

2. Laser à semi-conducteur selon la revendication 1, dans lequel la sous-couche (42) est en ZnO, GaN, AlN ou MgO.

3. Laser à semi-conducteur selon la revendication 1 ou 2, dans lequel le matériau électriquement isolant (32) est en MgO, CaO, SrO, BiO, BaO ou TiO2.

4. Laser à semi-conducteur selon l'une des revendications 1 à 3, **caractérisé en ce qu'**il comprend, en outre, deux miroirs (52, 54) disposés de part et d'autre de ladite couche mince (44) et formant avec ladite couche mince une cavité de résonance.

5. Laser à semi-conducteur selon l'une quelconque des revendications précédentes, dans lequel lesdits moyens de pompage électrique comprennent deux électrodes (46, 48) reliées à un générateur de courant, lesdites électrodes étant disposées sur ladite couche mince (44) et sur le revers dudit substrat (40) .

6. Laser à semi-conducteur selon l'une quelconque des revendications précédentes, dans lequel ladite couche mince (44) présente une épaisseur comprise entre 1 nm et 1 mm.

7. Procédé de réalisation d'un laser à semi-conducteur à ZnO polycristallin, **caractérisé en ce qu'**il consiste à:
- déposer, sur un substrat (40), une sous-couche (42) constituée par un film mince polycristallin d'un matériau dont les paramètres de réseau cristallin sont adaptés à ceux de ZnO, cette sous-couche étant constituée d'une mosaïque de grains ayant un axe cristallographique sensiblement [page 5 ligne 6 « très fortement orienté »] perpendiculaire au plan du film,
- faire croître, sur la sous-couche (42), une couche mince (44) de ZnO en présence d'un matériau électriquement isolant donnant lieu à une ségrégation de composition avec ZnO,
**caractérisé en ce que** :
ladite étape de croissance de la couche (44) s'effectue par grains de ZnO (30) ayant un axe cristallographique perpendiculaire au plan de la couche (44) et étant isolés électriquement les uns des autres en entourant chaque grain d'une paroi en ledit matériau électriquement isolant.

8. Procédé selon la revendication 7, dans lequel la sous-couche (42) est en ZnO, GaN, AlN ou MgO.

9. Procédé selon la revendication 7 ou 8, dans lequel le matériau électriquement isolant (32) est en MgO, CaO, SrO, Bio, BaO ou TiO2.

10. Procédé selon l'une des revendications 7 à 9, dans lequel lesdites couches (42, 44) sont déposées par pulvérisation magnétron RF ou ablation laser.

## Claims

1. A semiconductor laser made of polycrystalline ZnO comprising:
- a substrate (40),
- an underlayer (42), on this substrate (40), constituted of a polycrystalline thin film for which the crystallographic lattice parameters are matched to those of ZnO, and which has a mosaic type grain structure with grains having a crystallographic axis oriented perpendicular to the film plane;
- a thin film (44), on top of the underlayer (42), made up of grains (30) of ZnO
- an electrical pumping means (46, 48, 50) which causes current to flow perpendicular to the thin film plane (44),
**characterised by**:
grains of the thin film (44) having a crystallographic axis perpendicular to the thin film plane (44) and which are electrically insulated from each other by surrounding each grain with a grain boundary of electrically insulating material

2. The semiconductor laser of claim 1, wherein the underlayer (42) is formed from ZnO, GaN, AlN or MgO.

3. The semiconductor laser, as described in claims 1 or 2, in which the electrically insulating material (32) is MgO, CaO, SrO, BiO, BaO or Ti02.

4. A semiconductor laser, as described in claims 1 to 3, **characterized in that** it further comprises two mirrors (52, 54) placed on opposite sides of the aforementioned thin film (44) so as to form with this thin film a resonant cavity.

5. A semiconductor laser, according to any of the preceding claims, wherein the electrical pumping means comprise two electrodes (46, 48) connected to a current source; the electrodes being on the top of the film (44) and the back of the substrate (40).

6. A semiconductor laser, as described in any of the preceding claims, wherein the aforementioned thin film (44) has a thickness between 1 nm and 1 mm.

7. Method for fabricating a polycrystalline ZnO based semiconductor laser, comprising:
- deposition, on a substrate (40), of an underlayer (42) made up of a polycrystalline thin film in a material with crystallographic lattice parameters which are matched to those of ZnO, and which is made up of mosaic granular structure with grains having a crystallographic axis substantially perpendicular to the film plane,
- growing, on top of the underlayer (42), a thin film (44) of ZnO together with another, electrically insulating, element which segregates from the ZnO
**characterised by**:
an aforementioned step of growing the ZnO film (44) is such that the grains of ZnO (30) have a crystallographic axis perpendicular to the film plane (44) and are electrically insulated from each other by surrounding each grain with a boundary of a material which is electrically insulating.

8. The method of claim 7, wherein the underlayer (42) is formed of ZnO, GaN, AlN or MgO.

9. The method of claims 7 or 8, wherein the electrically insulating material (32) is MgO, CaO, SrO, BiO, BaO or Ti02.

10. The method of claims 7 or 8, whereby the aforementioned films (42, 44) are grown by RF magnetron sputtering or laser ablation.

## Patentansprüche

1. Halbleiterlaser mit polykristallinem ZnO, wobei er umfasst:
- ein Substrat (40),
- auf dem genannten Substrat (40) eine Unterschicht (42), die aus einer dünnen polykristalline Folien aus einem Material besteht, dessen Parameter des polykristallinen Netzes denen des ZnO angepasst sind, wobei diese Unterschicht aus einem Körnermosaik gebildet wird, dessen kristallografische Achse senkrecht zu Ebene der Folie verläuft,
- auf der Unterschicht (42) eine dünne Schicht (44) aus ZnO-Körnern (30), sowie
- elektrische Pumpmittel (46, 48, 50), die einen Strom senkrecht zur Ebene der dünnen Schicht (44) in Umlauf bringen können,
**dadurch gekennzeichnet, dass**
die Körner der dünnen Schicht (44) eine kristallografische Achse haben, die senkrecht zur Ebene der dünnen Schicht (44) verläuft, und die elektrisch voneinander isoliert sind, indem jedes Korn von einer Wand aus einem elektrisch isolierenden Material umgeben ist.

2. Halbleiterlaser gemäß Anspruch 1, bei dem die Unterschicht (42) aus ZnO, GaN, AlN oder MgO besteht.

3. Halbleiterlaster gemäß Anspruch 1 oder 2, bei dem das elektrisch isolierende Material (32) aus MgO, CaO, SrO, BiO, BaO oder TiO2 besteht.

4. Halbleiterlaser gemäß einem der Ansprüche 1 bis 3, **dadurch gekennzeichnet, dass** er ferner zwei Spiegel (52, 54) umfasst, die auf beiden Seiten der genannten dünnen Schicht (44) angeordnet sind und mit der genannten dünnen Schicht einen Resonanzraum bilden.

5. Halbleiterlaser gemäß einem der vorangehenden Ansprüche, bei dem die genannten elektrischen Pumpmittel zwei Elektroden (46, 48) umfassen, die an einem Stromgenerator angeschlossen sind, wobei die genannten Elektroden auf der genannten dünnen Schicht (44) und auf der Rückseite des genannten Substrats (40) angeordnet sind.

6. Halbleiterlaser gemäß einem der vorangehenden Ansprüche, bei dem die genannte dünne Schicht (44) eine Dicke zwischen 1 nm und 1 mm aufweist.

7. Herstellungsverfahren eines Halbleiterlasers mit polykristallinem ZnO, **dadurch gekennzeichnet, dass** es die folgenden Schritte umfasst:
- auf einem Substrat (40) eine Unterschicht (42) abscheiden, die aus einer dünnen polykristallinen Folie besteht aus einem Material, dessen Parameter des kristallinen Netzes denen des ZnO angepasst sind, wobei diese Unterschicht aus einem Körnermosaik besteht, dessen kristallografische Achse etwa senkrecht zur Ebene der Folie verläuft,
- auf der Unterschicht (42) eine dünne ZnO-Schicht (44) wachsen lassen, in Gegenwart eines elektrisch isolierenden Materials, was zu einer Zusammensetzungsseigerung mit ZnO führt,
**dadurch gekennzeichnet, dass**
der genannte Wachstumsschritt der Schicht (44) anhand ZnO-Körnern (30) erfolgt, deren kristallografische Achse senkrecht zur Ebene der Schicht (44) verläuft und die elektrisch voneinander isoliert sind, indem jedes Korn von einer Wand aus dem genannten elektrisch isolierenden Material umgeben wird.

8. Verfahren gemäß Anspruch 7, bei dem die Unterschicht (42) aus ZnO, GaN, AlN oder MgO besteht.

9. Verfahren gemäß Anspruch 7 oder 8, bei dem das elektrisch isolierende Material (32) aus MgO, CaO, SrO, BiO, BaO oder TiO2 besteht.

10. Verfahren gemäß einem der Ansprüche 7 bis 9, bei dem die genannten Schichten (42, 44) per Magnetronzerstäubung RF oder Laserabschmelzung abgeschieden werden.
